# EUROPEAN PATENT APPLICATION

(11) **EP 3 076 543 A1**
(43) Date of publication of application: **05.10.2016**
(21) Application number: 16163574.3
(22) Date of filing: 01.04.2016
(51) Int. Cl.: H02P 29/00, G01R 31/34, G01K 7/16, H02P 29/02

(54) **METHOD FOR PROTECTING THE INTEGRITY OF AN ELECTRIC MOTOR AND MEANS FOR CARRYING OUT SUCH METHOD**

(30) Priority: 03.04.2015 IT PD20150070
(71) Applicant: Dab Pumps S.p.A., 35035 Mestrino (Padova) (IT)
(72) Inventor: SINICO, Francesco, 36075 MONTECCHIO MAGGIORE VI (IT); PUCCIONI, Fabiano, 50051 CASTELFIORENTINO FI (IT)
(74) Representative: Modiano, Micaela Nadia

(57) **Abstract**

A method for protecting the integrity of an electric motor and to means for carrying out such method, the method comprising, in succession, the following steps:
- applying a direct voltage to the stator (11),
- identifying the linked currents and voltages at the stator (11), with analog filtering of their signals,
- analog-to-digital conversion of the signals of the linked currents and voltages identified in the preceding step,
- digital filtering of the digital signals of the direct voltages from the signals of the alternating voltages and digital filtering of the digital signals of the direct currents from the signals of the alternating currents,
- processing of the digital signals caused by the direct currents and voltages with calculation of stator resistance and of the temperature of the windings of the stator (11).

## Description

The present invention relates to a method for protecting the integrity of an electric motor and the means for carrying out such method.

As is known, in order to ensure the proper operation of an apparatus provided with an electric motor and compliance with safety regulations, it is essential to monitor the temperature of some parts of the electric motor, including the windings. This need is particularly evident for motors provided with an inverter, which can be subject to transients at high rotation speeds, during which the temperature of the motor tends to rise.

Continuous monitoring of the temperature is essential in these applications because it makes it possible to stop the rotation of the motor or to vary its speed in the event of overheating.

Nowadays these checks can be carried out using thermocouples to measure surface temperatures or temperatures in general of accessible parts.

A significant limitation of this method is therefore its inapplicability to measuring the temperature of the windings.

Another method known nowadays uses the relationship between the resistivity of the conducting materials and the temperature. It can be used, therefore, to measure the temperature reached in the windings, because it is based on the variation of the resistance of the metallic conductor as a function of the temperature.

However, this method does not allow continuous monitoring of the operation of the motor, because, with windings through which alternating currents flow, it requires the load to be disconnected in order to measure the heat resistance. Furthermore, there is a time interval from the moment of disconnection to the moment of measuring the resistance to heat of the winding, and this results in the measurement being affected by imprecision.

A further method is prescribed by the safety regulations (CEI IEC 60335) for controlling the temperature of stator windings in some synchronous and asynchronous electrical machines.

Such method involves the use of internal thermocouples which are put in place during the production of the motor, in points that otherwise would be inaccessible, therefore they are inserted for example between the windings of the stator.

This solution, in addition to complicating the process of producing the motor and making it more expensive, suffers problems of reliability, owing to the aging of the device and to the deterioration caused by the interruptions made to operation.

The aim of the present invention is to provide a method for protecting the integrity of an electric motor through the control of the temperature of the windings of the stator, eliminating or at least reducing the problems of the conventional methods.

Within this aim, an object of the invention is to preserve the electric motor from malfunctions owing to its overheating by varying its rotation speed as a function of the temperature.

This aim and this and other objects which will become better apparent hereinafter are achieved by a method for protecting the integrity of an electric motor, comprising in succession the following steps:
- applying a direct voltage to the stator,
- identifying the linked currents and voltages at the stator, with analog filtering of their signals,
- analog-to-digital conversion of the signals of said linked currents and voltages identified in the preceding step,
- digital filtering of the digital signals of the direct voltages from the signals of the alternating voltages and digital filtering of the digital signals of the direct currents from the signals of the alternating currents,
- processing of the digital signals caused by the direct currents and voltages with calculation of stator resistance and of the temperature of the windings of the stator.

The invention also relates to the means for carrying out the above method, which comprise:
- an alternating current electric motor,
- an inverter,
said means being characterized in that they comprise:
- a circuit for measuring the voltage in output from the stator.

Further characteristics and advantages of the invention will become better apparent from the detailed description that follows of a preferred, but not exclusive, embodiment of the method according to the invention, which is illustrated by way of non-limiting example in the accompanying drawings wherein:
- Figure 1 is a schematic diagram of a method according to the invention;
- Figure 2 is a diagram of the circuit of the final power stage of the inverter;
- Figure 3 is a diagram of an equivalent circuit for measuring the stator resistance;
- Figure 4 shows a detail of measuring the stator resistance,
- Figure 5 shows a detail of filtering the direct voltages and currents.

With reference to the figures, the method according to the invention comprises, in succession, the following steps.

With the motor in operation, and therefore powered by alternating current, a stator 11 is subjected to a direct voltage that is capable of inducing a direct current in the windings of the stator 11.

Subsequently the linked currents and the voltages at the stator 11 are identified by way of adapted resistive and capacitive networks and operational amplifiers 12, which condition their signals and perform a first analog filtering thereof.

The signals of the linked currents and voltages identified are converted, by way of an adapted converter 13, from analog to digital.

The digital signals of the linked currents and voltages, output by the converter 13, are sent to a computer program, the role of which will become clear hereinafter.

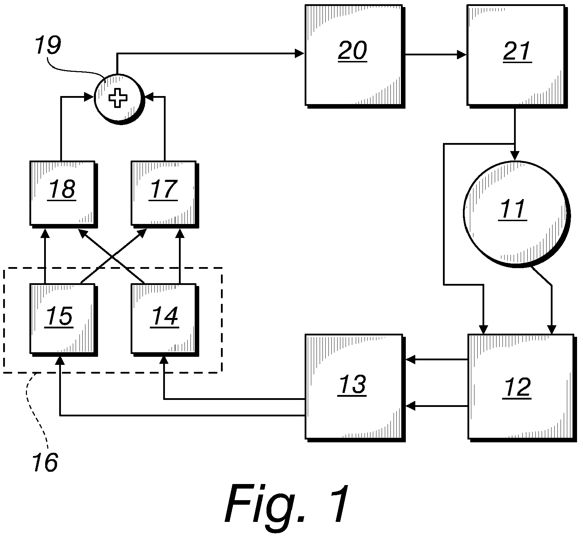

By way of such software the digital signals of the voltages are filtered in the step designated with the reference numeral 14 in the schematic diagram in Figure 1, which substantially corresponds to a digital filter for voltages, and at the same time the digital signals of the currents are filtered in the step designated with the reference numeral 15 in the same diagram, which corresponds to a digital filter for currents.

In this step therefore a digital filtering is carried out of the signals of the direct voltages from the signals of the alternating voltages, and at the same time the digital filtering is carried out of the signals of the direct currents from those of the alternating currents.

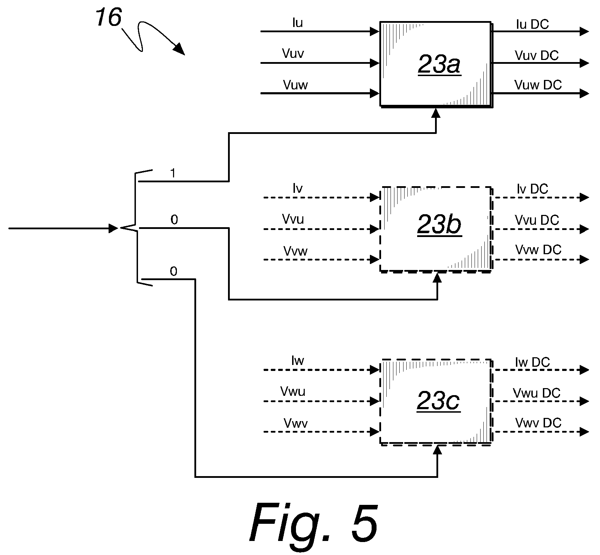

The portion corresponding to the filters is designated with the reference numeral 16 and a detail of the filtering is shown in Figure 5.

In the subsequent step the digital signals caused by the direct currents and by the direct voltages are sent to a safety module 17, and here they are processed in order to calculate the stator resistance and the temperature of the windings, using Ohm's law and the relationships between the resistance and the temperature of the conductor.

The method also comprises a step, which optionally can be carried out at the same time as the step just described, in which the digital signals caused by the alternating currents and by the alternating voltages are sent to a control module of the motor 18, and here they are processed for a step of driving the motor, with optional arrest or variation of the number of revolutions.

The temperature can also be controlled with the motor stopped, and in such case the direct voltage is applied to the stator without overlapping on the alternating voltage, which is used to drive the electric motor.

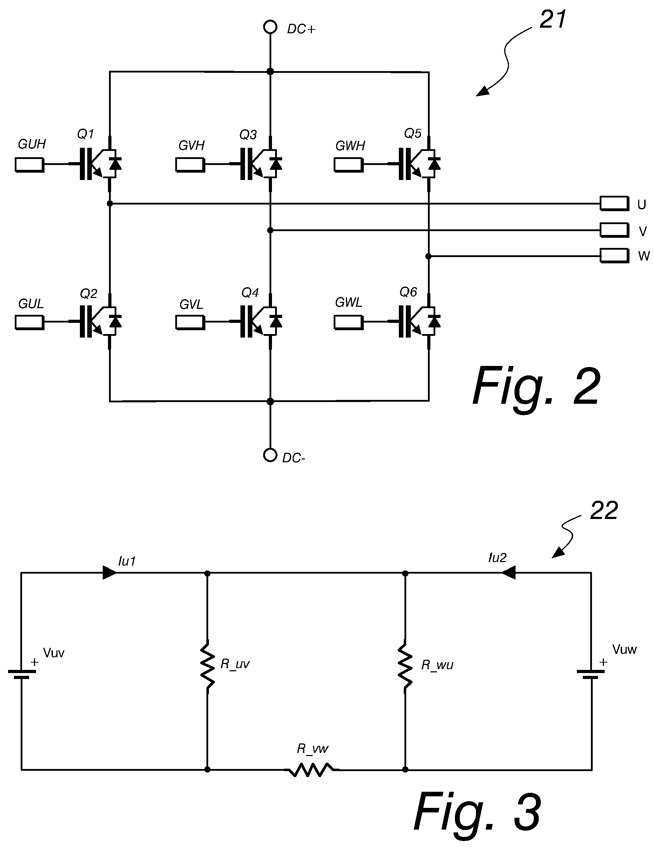

The step of driving the motor is set by the computer program, in step 19 of Figure 1, as a function of the detected temperature and as a function of the processed digital signals caused by the alternating currents, and is carried out by way of a modulation peripheral 20, which receives the commands from the computer program, and by way of a final power stage 21 of an inverter. The circuit of the final power stage 21 is shown in Figure 2, for a three-phase motor.

The modulation peripheral 20 generates both drive signals and also control signals, therefore signals for powering the rotation of the motor and signals for controlling the temperature. Such signals are generated by the peripheral 20 with pulse width modulation (PWM) in order to regulate the electric power and therefore also the speed of the electric motor.

The final power stage 21 transfers the electric power from the direct current bus of the inverter system to the output phases of the motor by way of modulation.

The direct voltage is generated at the final stage 21 of the inverter at the same time as the generation of the alternating components that power the rotation of the motor.

The direct voltage to be applied to the windings of the stator is therefore overlapped on the alternating voltage to calculate the temperature, repeating the method described up to now.

With this solution a current with a direct component flows through the windings, and this has effects on the concatenated flow and therefore on the torque applied.

Furthermore the application of the direct current brings the iron of the motor closer to magnetic saturation and, even when saturation is not reached, it makes the magnetization cycle dissymmetric, and therefore it shifts the current absorbed by the motor away from its sinusoidal behavior, with further effects on the torque.

For these reasons, the direct current to be overlapped must have an intensity equal to a small fraction, not higher than 10%, of the maximum value of the alternating current, in order not to generate appreciable effects on the torque applied to the motor. The signals generated by the modulation peripheral 20 for controlling the temperature must therefore be under lower voltage than the signals for rotating the motor.

In this manner the choice of measurement terminal can be independent of the progression of the alternating voltage.

Since the voltages applied to the motor are not capable of causing an absorption of direct currents, the direct current measured can be a consequence only of the application of a direct voltage and this makes it possible to calculate the resistance of the windings using Ohm's law.

Whatever the wiring of the windings of the motor, it is not possible to directly measure the resistance of each winding of the motor, except by using complex algebraic equations incorporating the measurable values (i.e. the multiplication of the vector of a linear combination of the measured linked direct voltages for the inverse matrix of the measured output direct currents).

However, it is acceptable to know the measurable resistances at the terminals of the motor, which are a function of the resistances of the individual windings, in order to have a measurement of the average resistance, and therefore of the average temperature, of the windings.

The method according to the invention applies to motors with any number of phases.

For a three-phase motor, the direct voltage is applied between one terminal and the other two terminals of the windings, as illustrated with the equivalent circuit 22 shown in Figure 3.

In fact, with the inverter in operation it is not possible to apply a direct voltage between only two terminals, because the one that is to be excluded from measurement cannot be left in high impedance. For this reason it is necessary to apply the voltage between one terminal and the other two terminals, and furthermore two separate direct voltage generators must be used.

In this manner one of the resistances gives a negligible contribution, ideally null, to the measurement and the other two resistances are in parallel.

It is advisable to periodically change measurement terminal.

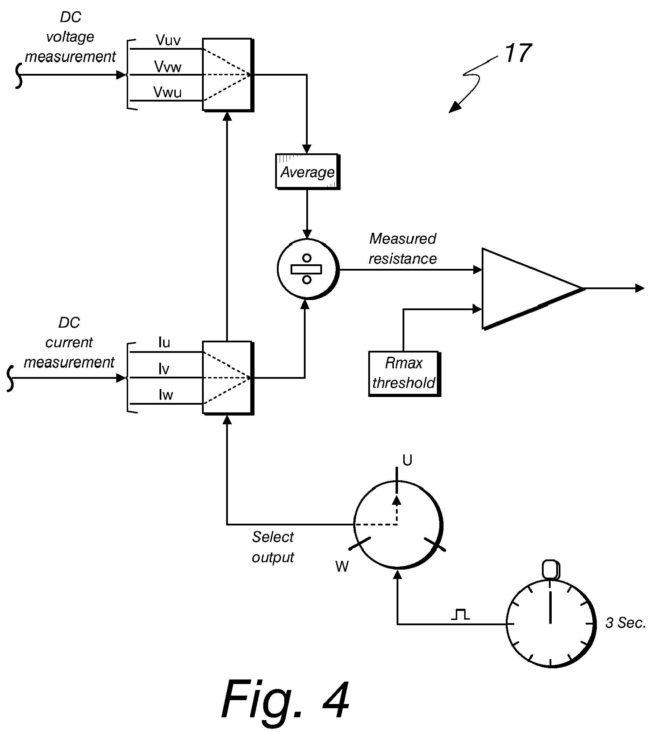

With experimental tests it is possible to obtain the duration of the transients owing to the change of the measurement terminal. During the transients the measured samples of current and voltage are not considered valid. If for example the transients last a half-second, and the measurement terminal is changed every three seconds, as shown in Figure 4, the resistance is effectively measured about 83% of the time.

Figure 4 in fact shows a detail of the measurement of the stator resistance, which is carried out in the safety module 17.

By choosing a certain measurement terminal, only the values related to that terminal are filtered. It is not necessary to filter the values for the other two terminals and therefore the filters 23a, 23b and 23c shown in Figure 5 are active for one third of the operating time.

In particular Figure 5 shows a detail of the filtering process at a certain moment in time.

As can be seen, the measurement output is selected and the corresponding filter is activated. In the figure the filter 23a is active, with the outline drawn in a continuous line. The outlines of the filters that are not active at that same moment are drawn in dotted lines.

The filters 23a, 23b, 23c are activated in succession, each in a successive cycle.

The means for carrying out the method described comprise: an alternating current electric motor, conveniently provided with a stator 11 and an inverter with a final power stage 21, and also comprise a circuit for measuring the voltage in output from the stator 11.

The means can also comprise a circuit in addition to the final power stage 21, for the generation of the direct voltage to the stator 11.

The means also comprise, as previously described, resistive and capacitive networks and operational amplifiers 12 downstream of the stator 11.

It should also be noted that the presence, in input to the analog-to-digital converter, of alternating values overlapped on the direct values makes it possible to increase the effective resolution with which measurement of the direct component is carried out.

The method is therefore reliable, it enables substantially continuous control of the temperature of the windings, and it does not require complex and expensive production processes of the motor.

In practice it has been found that the invention fully achieves the set aim and object by providing a method that, through the monitoring of the temperature of the windings of the stator, makes it possible to safeguard the electric motor from malfunctions owing to overheating.

Another advantage of the method according to the invention is that it uses the components of the inverter of the electric motor and it needs the addition only of the hardware part for the measurement and processing of the output voltage, and the filtering of the output current and voltage to support the software part.

The invention, thus conceived, is susceptible of numerous modifications and variations, all of which are within the scope of the appended claims. Moreover, all the details may be substituted by other, technically equivalent elements.

In practice the materials employed, provided they are compatible with the specific use, and the contingent dimensions and shapes, may be any according to requirements and to the state of the art.

The disclosures in Italian Patent Application No. PD2015A000070 (102015902342653) from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A method for protecting the integrity of an electric motor, comprising in succession the following steps:
- applying a direct voltage to the stator (11),
- identifying the linked currents and voltages at the stator (11), with analog filtering of their signals,
- analog-to-digital conversion of the signals of said linked currents and voltages identified in the preceding step,
- digital filtering of the digital signals of the direct voltages from the signals of the alternating voltages and digital filtering of the digital signals of the direct currents from the signals of the alternating currents,
- processing of the digital signals caused by the direct currents and voltages with calculation of stator resistance and of the temperature of the windings of the stator.

2. The method according to claim 1, **characterized in that** it comprises a step of processing the digital signals caused by the alternating voltages and currents.

3. The method according to claim 2, **characterized in that** it comprises a step of driving the motor as a function of the temperature of the windings and as a function of the processed digital signals caused by the alternating voltages and currents.

4. The method according to claim 1, **characterized in that** said direct voltage is applied to said stator (11) so as to overlap the alternating voltage for driving said electric motor.

5. The method according to claim 1, **characterized in that** the direct voltage at said stator (11), of a three-phase motor, is applied between one terminal and the other two of said windings.

6. Means for carrying out the method according to one or more of the preceding claims, comprising:
- an alternating current electric motor,
- an inverter,
said means being **characterized in that** they comprise a circuit for measuring the voltage in output from the stator (11).

7. The means according to claim 6, **characterized in that** they comprise a circuit in addition to the final power stage (21) of said inverter, in order to generate direct voltage at said stator (11).

8. The means according to claim 6, **characterized in that** it comprises resistive and capacitive networks and operational amplifiers (12) downstream of said stator (11), in order to identify the linked currents and voltages at the stator (11).
